# EUROPEAN PATENT SPECIFICATION

(11) **EP 2 473 832 B1**
(45) Date of publication and mention of the grant of the patent: **04.11.2015**
(21) Application number: 10763885.0
(22) Date of filing: 31.08.2010
(51) Int. Cl.: G01N 3/24, G01N 19/04, H01L 23/00

(54) **IMPROVEMENTS TO HIGH FORCE DIE SHEAR TOOLING**
VERBESSERTES SCHERTESTWERKZEUG MIT HOHER KRAFTANWENDUNG FÜR CHIPS
AMÉLIORATIONS APPORTÉES À UN OUTIL DE CISAILLEMENT DE PUCE À FORCE ÉLEVÉE

(30) Priority: 03.09.2009 GB 0915294; 18.01.2010 GB 201000758; 30.03.2010 GB 201005268
(43) Date of publication of application: 11.07.2012
(73) Proprietor: Xyztec BV, 5981 XC Panningen (NL)
(72) Inventor: SYKES, Robert J., Tendring Essex CO16 0BT (GB); DUPONT, Aubert D.V., NL-5988 NG Helden (NL)
(74) Representative: Gray, James
(86) International application number: PCT/NL2010/050545
(87) International publication number: WO 2011/028107

(56) References cited:
- JP-A- 1 075 938
- US-A- 5 767 414

## Description

This invention is for tooling to perform a shear test on a semiconductor die fixed to a substrate. Various forms of this type of test are known but problems can occur when testing at high forces. High forces being above about 20kgf. The invention is not limited to such "high forces" and may also be used with its advantages at any force.

Semiconductor die mounted to substrates are known. The die is fixed to the substrate by many different methods. Typical examples are solder, adhesive or a matrix of solder balls. Most if not all fixing methods are known to the skilled person. The size and shape of the die and substrate also come in many different forms all of which could be compatible with the invention. Generally the die are square or rectangular with a largest dimension in the range of 0.05mm to 40mm but the invention is not limited to this. The substrate can be a similar size to the die or many times larger. Both the die and the substrate are typically, substantially planer.

The shear test is performed to measure the quality of the bond. The test can be to the destruction of the bond or non destructive testing. The die material is typically hard and brittle. A common material being silicon. The bond is tested by clamping the substrate and applying a shear load to one side of the die. This produces high stresses at the clamp and load application points. The invention enables these stresses to be minimised by maintaining good alignment and distributing the test load on the substrate and die.

US 5767414 discloses a tool having automatic alignment for uniformly applying a controlled forced object.

JP 01075938 discloses an apparatus for testing bond strength of a film.

According to a first aspect of the invention there is provided a system for shear testing the bond between a semi-conductor die and a substrate, said system comprising a shear tool housing a shaft, a square or rectangular shear block rotatable on the shear tool so that a shear face of said block can self align into maximum contact with a die, characterized in that said block has a bearing in it that runs on the end of the shear tool shaft, and said shear tool has holes for porting vacuum for holding the shear block on the end of the shear tool.

According to a second aspect of the invention there is provided a method for shear testing the bond between a semi-conductor die and a substrate by a square or rectangular shear block that has a bearing in it that runs on the end of a shear tool shaft of a shear tool of a bond tester, said block being free to rotate on the shaft wherein said block is held in place by vacuum suction, and said bearing allows said block to rotate on said spindle so that a shear face on the block can self align for maximum contact with a die.

### Figures prefixed A

Fig A1 illustrates an isometric view of a typical substrate and die;
Fig A2 illustrates an isometric view of a shear tool and shear block test tool; and
Fig A3 illustrates sectional side view of the tool of Fig. A2.

The embodiment illustrated in figures A1-A3 is not part of the present invention.

Fig A1 illustrates a typical substrate 1 onto which is fixed die 2.

Fig A2 illustrates the substrate and die under test. Fig A3 is the same as Fig A2 but as a sectional side elevation. The substrate and die are placed on to base 3 of the tooling, one edge of the substrate being pushed into contact with the undercut face of block 4. Block 4 is rigidly fixed to base 1. Preferably this would be by a plurality of fixing screws 5. The substrate is then clamped to the base. Preferably this would be by fixing screws 6 but many other methods known to the skilled person could be used.

Preferably the clamping would be by a quick release toggle mechanism. Shear block 7 is placed on the opposite side of the die as illustrated. Shear tool 8 is fixed to the load cell of a "Bond Tester". A "Bond Tester" being known to the skilled person can apply a load in the direction of arrow 9. Preferably the shear tool 8 is cylindrical with a reduced end that is a clearance 110 fit in a hole in the shear block 7. The length of the reduced end of the shear tool is slightly less than the thickness of the shear block to enable clearance 111 such that the shear tool does not touch the substrate. The step between the two different diameters of the shear tool 8 is brought into contact with the top of shear block 7 and then raised to form clearance 112. Preferably the clearance 112 is less than clearance 111. Clearance 112 might typically be 5µm to 100µm and clearance 111, 10µm to 500µm. When aligned as described and illustrated the shear tool applies the test shear load to the die in the direction of arrow 9.

### Advantages of the system described above are,

Shear block 7 is free to rotate about the cylindrical axis of the shear tool such that it contacts the full surface of the edge of the die.

Shear block 7 can be a wear component and made from a relatively compliant material such that it locally deforms where it is in contact with the die further maximising its contact area with the die and thereby reducing the contact stress. Preferably the shear block 7 has an undercut 12 around one or more faces to minimise any lifting of the die from the substrate during a test. The shear block is likely to wear and each of the undercuts may be used before a new shear block is required. Shear faces may also be arranged on the top and bottom (top and bottom as drawn in the figures) of the block further increasing its life before a new block is required.

Clearance 111 results in the end of the shear tool being clear of the substrate but to be sufficiently aligned with the edge of the die so that the shear load is applied with a minimum tipping moment of the shear block.

Clearance 112 can be controlled by the bond tester as a means of thereby controlling clearance 111.

### Figures prefixed B

These embodiments of the invention have advantages when testing high force, stacked or tight access die applications. They may be use in any one of these cases or any multiple combinations of them. Die are often thin (0.025mm to 1.0mm) and so applying the shear test load to this thin edge also presents difficulties. Die are also stacked on top of each other or mounted "side by side" making access for load application difficult.

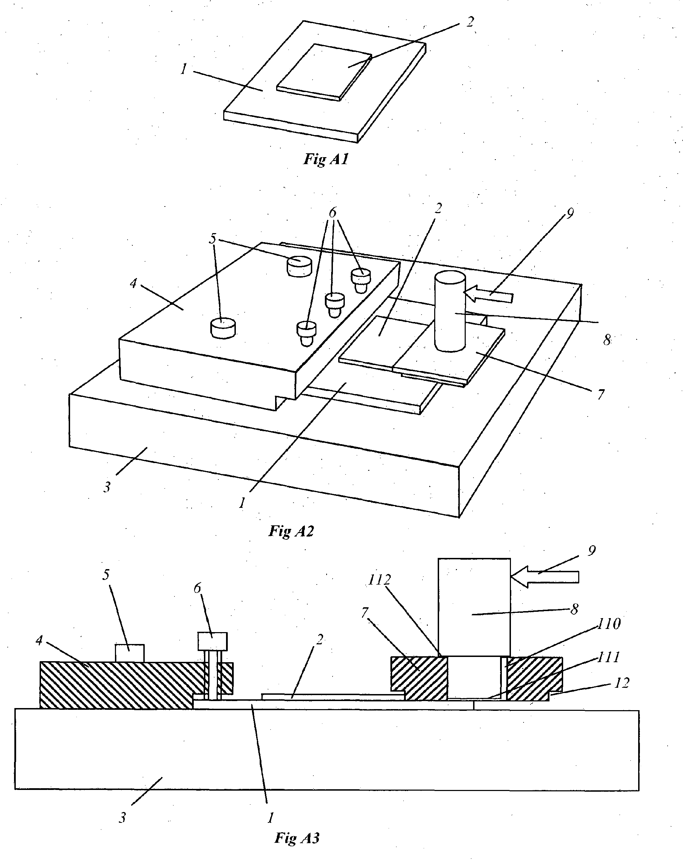

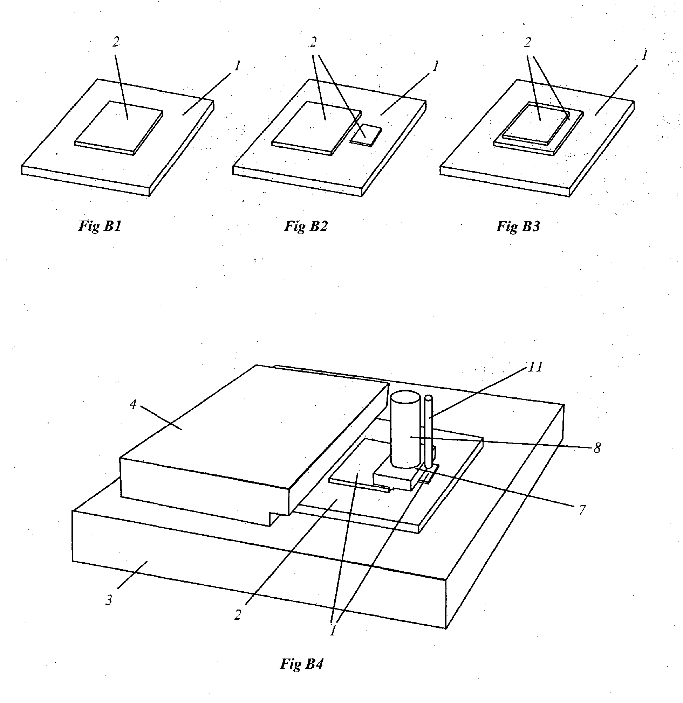

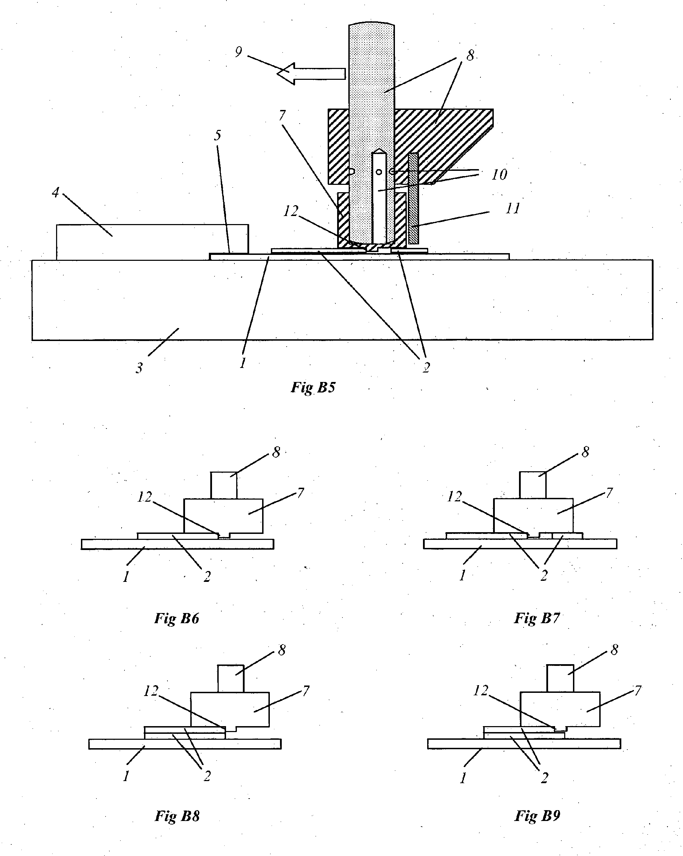

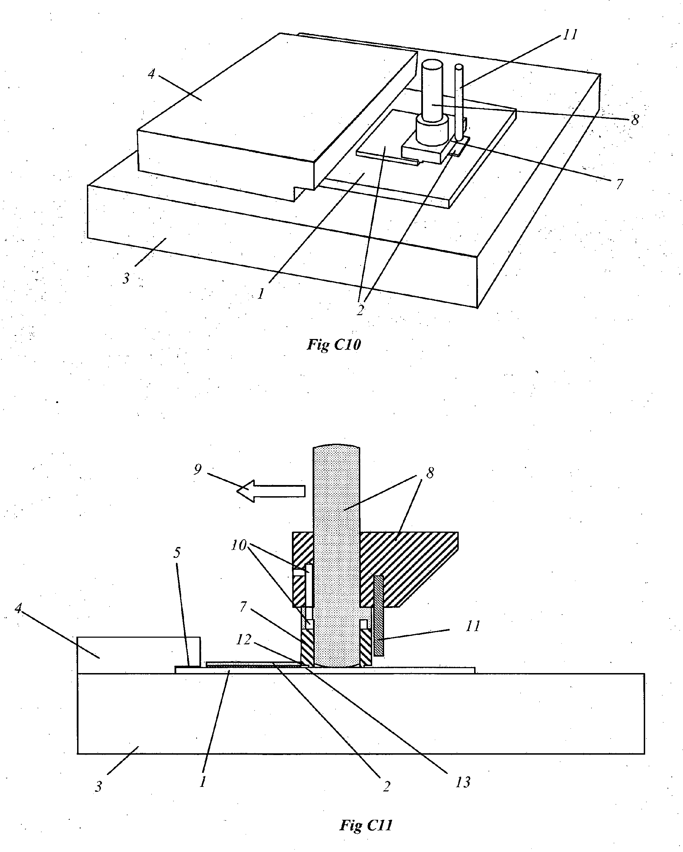

Features of these embodiments of the invention will be apparent from the following description of a preferred embodiment and reference to the accompanying drawing in which,
Fig B1 illustrates an isometric view of a typical substrate and single die;
Fig B2 illustrates an isometric view of a typical substrate with two dies attached which make access tight;
Fig B3 illustrates an isometric view of a typical substrate with two stacked dies;
Fig B4 illustrates an isometric view of a preferred embodiment of the invention;
Fig B5 illustrates side and sectional view of a preferred embodiment of the invention;
Fig B6 illustrates side view of a preferred embodiment of the invention testing a substrate with a single die;
Fig B7 illustrates side view of a preferred embodiment of the invention testing a substrate with tight access; and
Figs B8 & B9 illustrate side views of a preferred embodiment of the invention testing stacked die applications.

Figs B1, B2 and B3 illustrate typical substrates 1 onto which dies 2 are fixed.

Fig B4 illustrates the substrate and die under test by a preferred embodiment of the invention in a tight access application. Fig B5 is a similar illustration but as a side and sectional elevation. The substrate and die are placed on to base 3 of the tooling, one edge of the substrate being pushed into contact with the undercut face of block 4.

Block 4 is rigidly fixed to base 3. The substrate is then clamped to the base. In a preferred embodiment this would be by spring pressure and the undercut in the block at point 5 but many other methods know to the skilled person could be used. In another preferred embodiment the clamping would be by a quick release toggle mechanism.

Shear block 7 is placed on the opposite side of the die as illustrated. Shear tool 8 is fixed to the load cell of a "Bond Tester". A "Bond Tester" being known to the skilled person can apply a load in the direction of arrow 9. Shear block 7 is held on the end of shear tool 8 by a vacuum which is ported via holes 10 in the shear tool. Pin 11 mounted to the shear tool is in clearance with the shear block but controls it so that the shear block cannot rotate more than about +/- 5 degrees thus ensuring that the block is fitted in its correct nominal orientation.

To test a die the shear block is lowered on to the top face of the die as illustrated in Figs B6 to B9. The shear face 12 of the shear block being aligned to the side of the die with a slight clearance. The contact between the top of the die and underside of the shear block may then be controlled to a specific force or subsequently raised a "step back" distance as known to the skilled person. The shear load can then be applied by the shear tool moving in direction 9. When the shear contact surface 12 of the shear block touches the die the shear block is able to rotate on the shear tool until the contact surface is parallel to the edge of the die. This ensures the contact is distributed over the full surface of the contact edge on the die, thereby minimising stress concentrations.

Advantages of these embodiments of the invention are,

Shear block 7 is held on to shear tool 8 by vacuum suction

Shear block 7 has one or more contact faces that can be used to shear a die. When one side is worn the other may be used.

The shear faces on shear block 7 may be manufactured so that they are close to each other enabling them to be inserted into a tight space between the die to be tested and any other component mounted on the same substrate.

The shear faces on shear block 7 may be manufactured such that they protrude less from the under surface of the shear block than the thickness of the die. This ensures that the shear block cannot come into contact with the substrate and/or bond between the die and substrate during alignment and the shear test.

In a preferred embodiment the shear faces on the shear block are substantially close to the centre line of the shear tool spindle. This enables maximum alignment between the faces and the die before and during the test and minimises misalignment caused by test load deformations in the system.

### Figures prefixed C

Features of these embodiments of the invention will be apparent from the following description of preferred embodiments and reference to the accompanying drawing in which,

Fig C10 illustrates an isometric view of an alternative embodiment of the invention Fig C11 illustrates side and sectional view of the alternative embodiment of the invention

### Advantages of the invention are,

Figures C10 and C11 illustrate an alternative embodiment where the vacuum holding block 7 on to the tool is arranged to be on the top surface of the block. This embodiment has all the advantages of the previously described embodiments but also enables the hole in the block to go through it, as illustrated in Figure C11.

This design allows the tool 8 to descend below the top surface of the die and thereby minimising the bending moment on the block caused by the shear load it applies to the die.

Shear face 12 is raised above the substrate 1 surface by undercut 13. This controls the shear height of the shear face above the substrate by the height of the undercut, thereby ensuring when the bond breaks its surface is not damaged by the block and its failure mode can be inspected.

## Claims

1. A system for shear testing the bond between a semi-conductor die (4) and a substrate (3), said system comprising
a shear tool (8) housing a shaft,
a square or rectangular shear block (7)
rotatable on the shear tool (8) so that a shear face of said block (7) can self align into maximum contact with a die (4),
**characterized in that**:
said block (7) has a bearing in it that runs on the end of the shear tool shaft, and
said shear tool (8) has holes (10) for porting vacuum for holding the shear block (7) on the end of the shear tool (8).

2. A system according to claim 1, wherein said block (7) has a plurality of shear faces for use in testing the bond of said die (4).

3. A system according to claim 2, wherein said block (7) includes an undercut (12) around one or more faces thereof, each undercut defining a shear face.

4. A system according to claim 3, and including shear faces arranged on the top and bottom of said block (7).

5. A system according to claim 2, and having a square or rectangular protrusion on the underside of said block (7).

6. A system according to claim 5, wherein opposite shear faces of said block (7) are substantially close to the centreline of said shaft.

7. A system according to any preceding claim, wherein said bearing is a plain cylindrical hole.

8. A system according to any preceding claim, wherein said block (7) is of durable material to minimize wear at contact points with the die (4).

9. A system according to any of claims 1-7, wherein said block (7) is of a material softer than a die (4) to be tested therewith, said block (7) allowing some deformation at contact points with the die (4) to reduce test stress on the die (4) at said points, and reducing or eliminating damage to the die (4) at the point of load application in use.

10. A system according to any preceding claim, and adapted to provide vacuum suction through the end of said shaft, or through an annular channel at the side of said shaft to the top of said block (7).

11. A system according to any preceding claim, wherein rotation of said block (7) on said shaft is limited by a pin (11) mounted on said tool (8) at a clearance from said block (7).

12. A method for shear testing the bond between a semi-conductor die (4) and a substrate (3) by a square or rectangular shear block (7) that has a bearing in it that runs on the end of a shear tool shaft of a shear tool (8) of a bond tester, said block (7) being free to rotate on the shaft wherein said block (7) is held in place by vacuum suction, and said bearing allows said block (7) to rotate on said shaft so that a shear face on the block (7) can self align for maximum contact with a die (4).

13. A method according to claim 12, wherein said block (7) is held in place by vacuum suction applied through said shaft.

14. A method according to claim 12 or claim 13, wherein said block (7) is held in place by vacuum suction applied through an annular channel at the side of said shaft to the top of said block (7).

15. A method according to any of claims 12-14, wherein rotation of said block (7) on said shaft is limited by a pin (11) mounted to said shear tool (8) at a clearance from said block (7).

## Patentansprüche

1. System zum Schertesten der Verbindung zwischen einem Halbleiterchip (2) und einem Substrat (1), wobei das System umfasst:
ein Scherwerkzeug (8), in dem ein Schaft aufgenommen ist,
einen quadratischen oder rechteckigen Scherblock (7), der an dem Scherwerkzeug (8) drehbar ist, so dass sich eine Scherfläche des Blocks (7) eigenständig bis zum maximalen Kontakt mit einem Chip (2) ausrichten kann,
**dadurch gekennzeichnet, dass**:
der Block (7) im Inneren ein Lager aufweist, das auf dem Ende des Schafts des Scherwerkzeugs läuft, und
das Scherwerkzeug (8) Löcher (10) zum Anlegen von Vakuum aufweist, um den Scherblock (7) am Ende des Scherwerkzeugs (8) zu halten.

2. System nach Anspruch 1, wobei der Block (7) eine Mehrzahl von Scherflächen zur Verwendung beim Testen der Verbindung des Chips (2) aufweist.

3. System nach Anspruch 2, wobei der Block (7) eine Hinterschneidung (12) entlang einer oder mehrerer seiner Flächen aufweist, wobei jede Hinterschneidung eine Scherfläche bildet.

4. System nach Anspruch 3, das außerdem Scherflächen aufweist, die an der Oberseite und der Unterseite des Blocks (7) angeordnet sind.

5. System nach Anspruch 2, und mit einem quadratischen oder rechteckigen Vorsprung an der Unterseite des Blocks (7).

6. System nach Anspruch 5, wobei entgegengesetzte Scherflächen des Blocks (7) im Wesentlichen in der Nähe der Mittellinie des Schafts liegen.

7. System nach einem der vorhergehenden Ansprüche, wobei das Lager ein einfaches zylindrisches Loch ist.

8. System nach einem der vorhergehenden Ansprüche, wobei der Block (7) aus widerstandsfähigem Material besteht, um den Verschleiß an Kontaktpunkten mit dem Chip (2) zu minimieren.

9. System nach einem der Ansprüche 1 bis 7, wobei der Block (7) aus einem Material besteht, das weicher ist als ein damit zu prüfender Chip (2), wobei der Block (7) eine gewisse Verformung an Kontaktpunkten mit dem Chip (2) zulässt, um die Belastung des Chips (2) durch den Test an diesen Punkten zu reduzieren, und um Schäden an dem Chip (2) an dem Lastangriffspunkt bei der Verwendung zu reduzieren oder auszuschließen.

10. System nach einem der vorhergehenden Ansprüche, und dafür ausgebildet, eine Vakuumansaugung über das Ende des Schafts oder über einen ringförmigen Kanal an der Seite des Schafts für die Oberseite des Blocks (7) bereitzustellen.

11. System nach einem der vorhergehenden Ansprüche, wobei die Drehung des Blocks (7) an dem Schaft durch einen Stift (11) begrenzt wird, der an dem Werkzeug (8) in einem Abstand von dem Block (7) montiert ist.

12. Verfahren zum Schertesten der Verbindung zwischen einem Halbleiterchip (2) und einem Substrat (1) mittels eines quadratischen oder rechteckigen Scherblocks (7), der im Inneren ein Lager aufweist, das auf dem Ende eines Scherwerkzeugschafts eines Scherwerkzeugs (8) eines Verbindungstester läuft, wobei sich der Block (7) frei auf dem Schaft drehen kann, wobei der Block (7) durch Vakuumansaugung an seinem Platz gehalten wird, und wobei das Lager dem Block (7) ermöglicht, sich auf dem Schaft so zu drehen, dass sich eine Scherfläche an dem Block (7) eigenständig bis zum maximalen Kontakt mit einem Chip (2) ausrichten kann.

13. Verfahren nach Anspruch 12, wobei der Block (7) durch Vakuumansaugung, die über den Schaft ausgeübt wird, am Platz gehalten wird.

14. Verfahren nach Anspruch 12 oder Anspruch 13, wobei der Block (7) durch Vakuumansaugung, die über einen ringförmigen Kanal an der Seite des Schafts auf die Oberseite des Blocks (7) ausgeübt wird, am Platz gehalten wird.

15. Verfahren nach einem der Ansprüche 12 bis 14, wobei die Drehung des Blocks (7) auf dem Schaft durch einen Stift (11) begrenzt wird, der an dem Scherwerkzeug (8) in einem Abstand von dem Block (7) montiert ist.

## Revendications

1. Système permettant de tester par cisaillement la liaison entre une puce à semi-conducteur (4) et un substrat (3), ce système comprenant :
un outil de cisaillement (8) renfermant une tige,
un bloc de cisaillement (7) carré ou rectangulaire mobile en rotation sur l'outil de cisaillement (8) de sorte qu'une face de cisaillement de ce bloc (7) puisse s'aligner automatiquement selon un contact maximum avec la puce (4),
**caractérisé en ce que**
le bloc (7) est équipé à sa partie interne d'un support qui se déplace sur l'extrémité de la tige de l'outil de cisaillement, et
l'outil de cisaillement (8) comprend des orifices (10) de transmission de vide permettant de maintenir le bloc de cisaillement (7) à l'extrémité de l'outil de cisaillement (8).

2. Système conforme à la revendication 1, dans lequel le bloc (7) comporte un ensemble de faces de cisaillement destinées à être utilisées pour tester la liaison de la puce (4).

3. Système conforme à la revendication 2, dans lequel le bloc (7) comprend une contre-dépouille (12) autour de l'une ou de plusieurs de ses face(s), chaque contre-dépouille définissant une face de cisaillement.

4. Système conforme à la revendication 3, comprenant des faces de cisaillement positionnées à la partie supérieure et à la partie inférieure du bloc (7).

5. Système conforme à la revendication 2, comprenant une saillie carrée ou rectangulaire située sur la face inférieure du bloc (7).

6. Système conforme à la revendication 5, dans lequel les faces de cisaillement opposées du bloc (7) sont situées essentiellement au voisinage de l'axe central de la tige.

7. Système conforme à l'une quelconque des revendications précédentes, dans lequel le support est un perçage cylindrique plat.

8. Système conforme à l'une quelconque des revendications précédentes, dans lequel le bloc (7) est en un matériau résistant pour réduire au maximum l'usure au niveau des points de contact avec la puce (4).

9. Système conforme à l'une quelconque des revendications 1 à 7, dans lequel le bloc (7) est réalisé en un matériau plus mou que la puce (4) devant être testée avec celui-ci, ce bloc (7) permettant une certaine déformation au niveau des points de contact avec la puce (4) pour réduire les contraintes sur la puce (4) au niveau de ces points et réduire ou supprimer l'endommagement de la puce (4) au niveau du point de l'application de charge en cours d'utilisation.

10. Système conforme à l'une des revendications précédentes et susceptible de permettre l'aspiration sous vide au travers de l'extrémité de la tige ou au travers d'un canal annulaire s'étendant sur le côté de la tige vers le haut du bloc (7).

11. Système conforme à l'une des revendications précédentes dans lequel la rotation du bloc (7) sur la tige est limitée par une broche (11) montée sur l'outil (8) au niveau d'un dégagement du bloc (7).

12. Procédé permettant de tester par cisaillement la liaison entre une puce à semi-conducteur (4) et un substrat (3) par un bloc de cisaillement (7) carré ou rectangulaire qui est équipé d'un support qui se déplace à l'extrémité de l'arbre d'un outil de cisaillement (8) d'un testeur de liaison, ce bloc (7) étant monté libre en rotation sur l'arbre, et étant maintenu en place par aspiration sous vide et le support permettant au bloc (7) de tourner sur la tige de sorte qu'une face de cisaillement du bloc (7) puisse s'aligner automatiquement pour permettre un contact maximum avec la puce (4).

13. Procédé conforme à la revendication 12, selon lequel le bloc (7) est maintenu en place par aspiration sous vide appliquée au travers de la tige.

14. Procédé conforme à la revendication 12 ou 13 selon lequel le bloc (7) est maintenu en place par aspiration sous vide appliquée au travers d'un canal annulaire situé sur un côté de la tige et s'étendant vers le dessus du bloc (7).

15. Procédé conforme à l'une quelconque des revendications 12 à 14, selon lequel la rotation du bloc (7) sur la tige est limitée par une broche (11) montée sur l'outil de cisaillement (8) au niveau d'un dégagement du bloc (7).
